(19) **Europäisches Patentamt**

**European Patent Office**

**Office européen des brevets**

(11) **EP 0 948 137 B1**

(12) **EUROPÄISCHE PATENTSCHRIFT**

(45) Veröffentlichungstag und Bekanntmachung des Hinweises auf die Patenterteilung:
**22.12.2004 Patentblatt 2004/52**

(51) Int Cl.⁷: **H03K 17/97**

(21) Anmeldenummer: **99106563.2**

(22) Anmeldetag: **30.03.1999**

(54) **Berührungsloser Rotationsschalter mit drei Schaltpositionen**

Noncontact rotary switch with three switching positions

Commutateur rotatif sans contact ayant trois positions de commutation

(84) Benannte Vertragsstaaten:
**DE ES FR GB IT SE**

(30) Priorität: **31.03.1998 DE 19814379**

(43) Veröffentlichungstag der Anmeldung:
**06.10.1999 Patentblatt 1999/40**

(73) Patentinhaber: **Tyco Electronics Logistics AG**
**9323 Steinach / SG (CH)**

(72) Erfinder:
• **Jansseune, Luc**
**31100 Toulouse (FR)**
• **Brand, Robert**
**68794 Oberhausen-Rheinhausen (DE)**
• **Lindner, Matthias**
**69124 Heidelberg (DE)**
• **Kempf, Dominik**
**68165 Mannheim (DE)**

(74) Vertreter: **Klunker . Schmitt-Nilson . Hirsch**
**Winzererstrasse 106**
**80797 München (DE)**

(56) Entgegenhaltungen:
WO-A-91/13494            DE-U- 29 510 696
US-A- 4 137 512          US-A- 5 578 977

**Beschreibung**

Die Erfindung betrifft einen berührungslosen Rotationsschalter mit drei Schaltpositionen.

In vielen Anwendungsgebieten werden bisher verwendete mechanische Schalter durch berührungslose Schalter mit Magnetfeldsensoren ersetzt. Ein Anwendungsgebiet, bei dem sich diese Entwicklung sehr deutlich abzeichnet, ist derzeit der Kraftfahrzeugsektor. Grundelement eines berührungslosen Rotationsschalters ist in vielen Fällen ein Hall-Sensor. Hall-Sensoren bieten überdies den Vorteil, daß sie sich zusammen mit Auswerteschaltungen als integrierte Schaltkreise auf einem Halbleiterchip integrieren lassen. Bei der Verarbeitung der Sensorsignale können analoge, zumeist lineare Ausgangssignale, digitale Ausgangssignale und Differenzsignale zweier Sensoren ausgewertet werden.

Aus DE 295 10 696 U1 ist ein berührungsloser Rotationsschalter mit mindestens drei Schaltpositionen bekannt. Im Rotor des Schalters sind in axialer Richtung aufeinanderfolgend zwei segmentförmige Dauermagneten angeordnet. Diesen Dauermagneten sind radial zum Rotor lagefest angeordnete Magnetfeldsensoren zugeordnet. In einer Ruhestellung durchsetzen alle Magnetsegmente die zugeordneten Magnetfeldsensoren mit einem Magnetfluß. Durch Verdrehung des Rotors können verschiedene Schaltkombinationen eingestellt werden, welche sich durch die jeweils in unterschiedlicher Weise vom Magnetfluß durchsetzten Sensorelemente ergeben. Bei einem derartigen Rotationsschalter sind jedoch umfangreiche und teure Abschirmungen vorzusehen, um eine Manipulation des Schaltzustandes durch externe Magnetfelder ausschließen zu können.

Der Erfindung liegt daher das Ziel zugrunde, einen Rotationsschalter, welcher sich insbesondere für die Verwendung bei Kfz-Türschlössern eignet, zu schaffen, bei welchem ein Verzicht auf eine separate Abschirmung möglich ist. Speziell soll die Einwirkung eines externen Magnetfeldes bei Schließsystemen mit je einem Entriegelungssensor und einem Verriegelungssensor immer zuerst zu einem Ansprechen des Verriegelungssensors führen.

In einer ersten erfindungsgemäßen Lösung wird dieses Ziel durch einen berührungslosen Rotationsschalter mit drei Schaltpositionen sowie

- einem im wesentlichen zylinderförmigen Rotor, in welchem ein Dauermagnet angeordnet ist,
- einem ersten lagefest angeordneten Magnetfeldsensor zur Erzeugung eines Verriegelungssignals, welcher bei verschwindendem Magnetfeld aktiviert ist, und
- einem zweiten lagefest angeordneten Magnetfeldsensor zur Erzeugung eines Entriegelungssignals, welcher bei verschwindendem Magnetfeld aktiviert ist und eine betragsmäßig niedrigere Schaltschwelle als der erste Magnetfeldsensor aufweist bzw. in einer Ruhestellung des Rotors betragsmäßig stärker als der erste Magnetfeldsensor von dem durch den Dauermagneten hervorgerufenen Magnetfluß durchsetzt ist,

wobei in einer Ruhestellung des Rotors beide Magnetfeldsensoren von dem durch den Dauermagneten hervorgerufenen Magnetfluß durchsetzt und infolgedessen deaktiviert sind, während in einer Entriegelungsstellung nur der erste Magnetfeldsensor und in einer Verriegelungsstellung nur der zweite Magnetfeldsensor von dem durch den Dauermagneten hervorgerufenen Magnetfluß durchsetzt ist, erreicht.

Durch die betragsmäßig niedrigere Schaltschwelle des Entriegelungssensors bzw. aufgrund der in der Ruhestellung des Rotors betragsmäßig stärkeren Durchsetzung des Entriegelungssensors von dem durch den Dauermagneten hervorgerufenen Magnetfluß wird bei dem Versuch, in der Ruhestellung des Rotors das vom Dauermagneten hervorgerufene Magnetfeld aufzuheben, immer zuerst der Verriegelungssensor aktiviert. Eine separate Aktivierung des.Entriegelungssensors mittels eines gewöhnlichen Permanentmagneten ist in der Ruhestellung des Rotors somit nicht möglich. Die Schwellwertdifferenz zwischen den beiden Magnetfeldsensoren bzw. die Durchflutungsdifferenz in der Ruhestellung des Rotors ist vom Abstand der Sensoren abhängig. Unterschiedliche magnetische Durchflutungen an den beiden Magnetfeldsensoren in der Ruhestellung des Rotors lassen sich beispielsweise durch unterschiedliche Dicken des Dauermagneten oder durch unterschiedliche Magnetmaterialien erzielen. Der Dauermagnet ist in Anpassung an den im wesentlichen zylindrischen Rotor vorzugsweise kreissegmentartig geformt.

Bei einer vorteilhaften Ausgestaltung der ersten erfindungsgemäßen Lösung ist der im Rotor angeordnete Dauermagnet in axialer Richtung magnetisiert, und die beiden Magnetfeldsensoren sind in axialer Richtung auf den Rotor folgend angeordnet. Alternativ dazu kann der Dauermagnet auch in radialer Richtung magnetisiert sein. In diesem Fall sind die beiden Magnetfeldsensoren in axialer Richtung auf den Rotor folgend angeordnet.

Gemäß einer bevorzugten Ausgestaltung erzeugen beide Sensoren jeweils nur in deaktiviertem Zustand - also bei verschwindendem Magnetfeld - ein von Null verschiedenes Entriegelungs- bzw. Verriegelungssignal. In der Entriegelungsstellung des Rotors liefert damit lediglich der Verriegelungssensor ein Signal, während in der Verriegelungsstellung lediglich der Entriegelungssensor ein Signal liefert. Des weiteren kann beiden Magnetfeldsensoren jeweils ein Inverter zur Negierung des logischen Zustandes nachgeschaltet sein, wodurch die Schaltstellung des Rotors in positiver Logik darstellbar ist. Zur Zustandsspeicherung bietet es sich an, den Sensoren und den Invertern ein RS-Flip-Flop nachzuschalten. Allerdings ist eine Invertierung der Sensorsignale nicht unbedingt erforderlich, da sich den Magnetfeldsensoren auch ein $\overline{RS}$-Flip-Flop als Zustandsspeicher nachschalten läßt, welches sich durch Verwendung von NAND-Bausteinen einfacher realisieren läßt als ein RS-Flip-Flop inklusive der zusätzlich erforderlichen Inverter.

In einer zweiten Lösung wird das der Erfindung zugrundeliegende Ziel durch einen berührungslosen Rotationsschalter mit drei Schaltpositionen sowie

- einem im wesentlichen zylinderförmigen Rotor, in welchem ein erster Dauermagnet angeordnet ist,
- einem zweiten im Rotor angeordneten Dauermagneten, welcher gegensinnig zum ersten Dauermagneten magnetisiert ist,
- einem ersten lagefest angeordneten Magnetfeldsensor zur Erzeugung eines Verriegelungssignals, welcher bei verschwindendem Magnetfeld deaktiviert ist, und
- einem zweiten Magnetfeldsensor zur Erzeugung eines Entriegelungssignals, welcher bei verschwindendem Magnetfeld aktiviert ist,

wobei der erste Magnetfeldsensor nur in einer Verriegelungsstellung des Rotors von einem Magnetfluß, dem durch den ersten Dauermagneten hervorgerufenen Magnetfluß, durchsetzt und infolgedessen aktiviert ist, und wobei der zweite Magnetfeldsensor nur in einer Verriegelungsstellung des Rotors und in einer Ruhestellung des Rotors von einem Magnetfluß, dem durch den zweiten Dauermagneten hervorgerufenen Magnetfluß, durchsetzt und infolgedessen deaktiviert ist, erreicht.

Bei dieser erfindungsgemäßen Lösung wirkt jeweils ein Dauermagnet mit einem Magnetfeldsensor zusammen, wodurch die Erkennung unterschiedlicher Schaltstellungen des Rotors möglich ist. Da die beiden Dauermagneten gegensinnig magnetisiert sind und einer der beiden Magnetfeldsensoren nordfeldsensitiv ist, während der andere Magnetfeldsensor südfeldsensitiv ist, wird beim Versuch, das den Entriegelungssensor im Ruhezustand durchsetzende Magnetfeld durch ein externes Magnetfeld aufzuheben, zuerst der Verriegelungssensor aktiviert. Somit ist ein separates Aktivieren des Entriegelungssensors durch ein externes Magnetfeld auch bei der zweiten erfindungsgemäßen Lösung nicht möglich.

Bei einer vorteilhaften Ausgestaltung der zweiten erfindungsgemäßen Lösung sind die im Rotor angeordneten Dauermagneten in axialer Richtung magnetisiert, und die beiden Magnetfeldsensoren sind in axialer Richtung auf den Rotor folgend angeordnet. Vorteilhafterweise schließt sich der erste Dauermagnet dabei radial an den zweiten Dauermagneten an. Alternativ können die Dauermagneten auch in radialer Richtung magnetisiert sein. In diesem Fall sind die beiden Magnetfeldsensoren in axialer Richtung auf den Rotor folgend angeordnet, wobei sich der erste Dauermagnet vorzugsweise axial an den zweiten Dauermagneten anschließt.

Entsprechend einer bevorzugten Ausgestaltung erzeugt der erste Magnetfeldsensor nur im aktivierten Zustand ein von Null verschiedenes Verriegelungssignal, während der zweite Magnetfeldsensor nur im deaktivierten Zustand ein von Null verschiedenes Entriegelungssignal erzeugt. Des weiteren kann einem der beiden Magnetfeldsensoren ein Inverter zur Negierung des logischen Zustandes nachgeschaltet sein. Ist das Verriegelungssignal des ersten Magnetfeldsensors negiert, ergeben sich der ersten erfindungsgemäßen Lösung entsprechende Signalverhältnisse.

Die beiden Dauermagneten sind in Anpassung an den im wesentlichen zylindrischen Rotor vorzugsweise kreissegmentförmig, wobei der mit dem Verriegelungssensor korrespondierende Dauermagnet sich vorteilhafterweise über einen kleineren Winkelbereich erstreckt als der mit dem Entriegelungssensor korrespondierende Dauermagnet. Auf diese Weise ist der Verriegelungssensor in der Ruhestellung des Rotors von keinem Dauermagneten beeinflußt.

Bei jeder der beiden erfindungsgemäßen Lösungen ist die Realisierung der Magnetfeldsensoren durch Hall-Elemente vorteilhaft, da sich die Auswerteelektronik bzw. der Zustandsspeicher auf einfache Weise zusammen mit den Hall-Elementen auf einem Halbleiterchip integrieren läßt.

Die Erfindung wird nachfolgend an Ausführungsbeispielen anhand der Zeichnung näher erläutert. Es zeigt

Figur 1 einen erfindungsgemäßen Rotationsschalter mit einem axial magnetisierten Dauermagneten in perspektivischer Darstellung,

Figur 2 einen erfindungsgemäßen Rotationsschalter mit einem radial magnetisierten Dauermagneten in perspektivischer Darstellung,

Figur 3a einen erfindungsgemäßen Rotationsschalter mit zwei axial magnetisierten Dauermagneten in der Seitenansicht,

Figur 3b den Rotationsschalter gemäß Figur 3a in der Draufsicht und

Figur 4a einen erfindungsgemäßen Rotationsschalter mit zwei radial magnetisierten Dauermagneten in der Seitenansicht,

Figur 4b den Rotationsschalter gemäß Figur 4a in der Draufsicht.

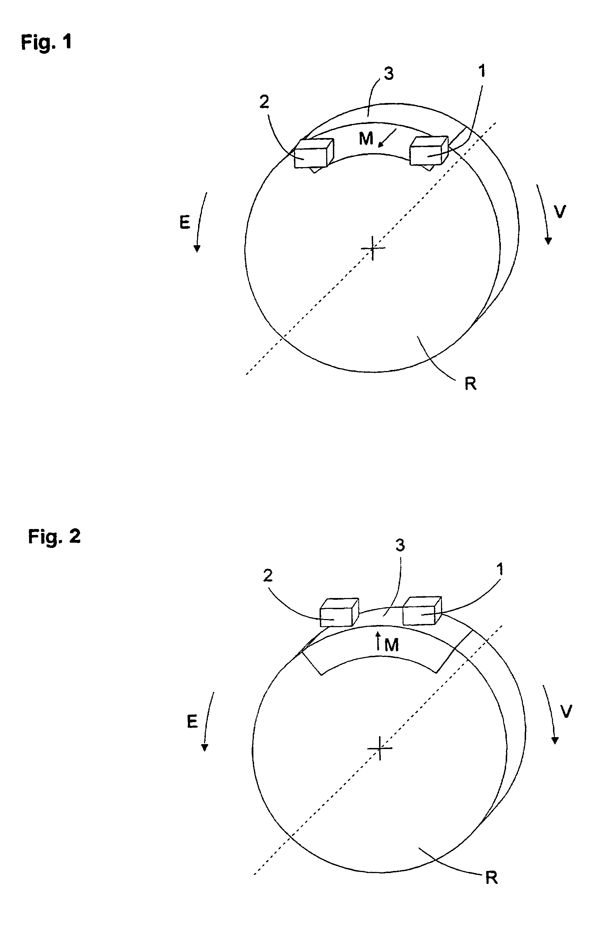

Der in Figur 1 dargestellte Rotationsschalter R weist einen im wesentlichen zylindrischen Rotor R auf, in welchem ein axial magnetisierter Dauermagnet 3 angeordnet ist, und einen ersten Magnetfeldsensor 1 als Verriegelungssensor und einen zweiten Magnetfeldsensor 2 als Entriegelungssensor. In einer in Figur 1 dargestellten Ruhestellung des Rotors R sind beide Magnetfeldsensoren 1 und 2 von dem Dauermagneten 3 überdeckt und dadurch deaktiviert. Bei Verdrehung des Rotors R in Richtung "V" bzw. in einen Verriegelungszustand wird der Verriegelungssensor 1 nicht mehr vom Magnetfluß durchsetzt und demzufolge aktiviert, während der Entriegelungssensor 2 deaktiviert bleibt. Bei Verdrehung des Rotors R in Richtung "E" bzw. in einen Entriegelungszustand ergeben sich entsprechend umgekehrte Verhältnisse. Jeder der drei Rotorstellungen ist somit eine eindeutige Zustandskombination der Magnetfeldsensoren 1 und 2 zugeordnet.

Ist überdies beim Verriegelungssensor 1 die Schaltschwelle betragsmäßig höher als beim Entriegelungssensor 2, so erfolgt durch ein externes, den Zustand des Rotationsschalters manipulierendes Magnetfeld zuerst eine Aktivierung des Verriegelungssensors 1, wodurch der Rotationsschalter in den Verriegelungszustand übergeht. Eine nachfolgende Aktivierung des Entriegelungssensors 2 kann keine Aufhebung dieses Zustandes bewirken. Somit ist eine separate Aktivierung des Entriegelungssensors 2 unabhängig von einer Beeinflussung des Verriegelungssensors 1 mit einem herkömmlichen Dauermagneten nicht möglich. Vorzugsweise ist den beiden Magnetfeldsensoren 1 und 2 ein $\overline{RS}$-Flip-Flop als Zustandsspeicher nachzuschalten, wodurch die bisher für die Zustände der Magnetfeldsensoren 1 und 2 verwendete negative Logik kompensiert wird.

Figur 2 zeigt ein alternatives Ausführungsbeispiel zu dem Rotationsschalter gemäß Figur 1, bei welchem der Dauermagnet 3 in radialer Richtung magnetisiert ist und die Magnetfeldsensoren 1 und 2 in radialer Richtung auf den Rotor R folgend angeordnet sind. Der in Figur 2 dargestellte Rotationsschalter weist ansonsten die gleiche Funktionalität auf wie der Rotationsschalter gemäß Figur 1.

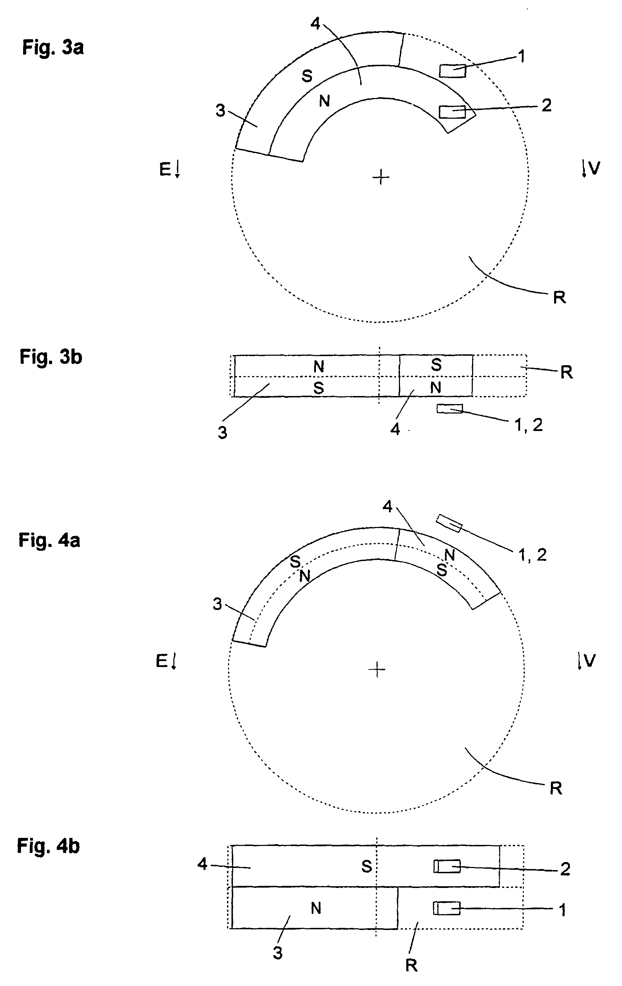

In Figur 3a und Figur 3b ist ein weiterer, gegen externe Manipulation geschützter Rotationsschalter dargestellt, welcher neben einem zylindrischen Rotor R zwei radial aufeinanderfolgende Dauermagneten 3 und 4 sowie zwei Magnetfeldsensoren 1 und 2 aufweist. Beide Dauermagneten 3 und 4 sind in axialer Richtung und gegensinnig zueinander magnetisiert. Ein zweiter Dauermagnet 4 schließt sich radial an den äußeren ersten Dauermagneten 3 an, welcher sich über einen geringeren Winkelbereich erstreckt. Dadurch ist in einer Ruhestellung des Rotors R lediglich ein zweiter Magnetfeldsensor 2 als Entriegelungssensor von dem zugehörigen zweiten Dauermagneten 4 überdeckt und damit deaktiviert. Der erste Magnetfeldsensor 1 als Verriegelungssensor ist nicht vom Feld des ihm zugeordneten ersten Dauermagneten 3 erfaßt und auf diese Weise ebenfalls deaktiviert.

Im vorliegenden Ausführungsbeispiel ist der Verriegelungssensor 1 südfeldsensitiv und der Entriegelungssensor 2 nordfeldsensitiv. Um die Auswertung der Sensorsignale zu vereinfachen, ist das Signal des Verriegelungssensors 1 intern negiert, so daß in Ruhestellung des Rotors R beide Magnetfeldsensoren 1 und 2 von Null verschiedene Signale liefern. Eine Verdrehung des Rotors in Richtung "V" bzw. in einen Verriegelungszustand bewirkt eine Aktivierung des Verriegelungssensors, während eine Verdrehung des Rotors R in Richtung "E" bzw. in eine Entriegelungsstellung eine Aktivierung des Entriegelungssensors 2 bewirkt. Somit kann jedem Schaltzustand des Rotors R eine eindeutige Zustandskombination der beiden Magnetfeldsensoren 1 und 2 zugeordnet werden.

Eine separate Deaktivierung des Entriegelungssensors 2 in Ruhestellung des Rotors R durch einen externen Dauermagneten ist nicht möglich, da hierdurch zunächst der Verriegelungssensor 1 aktiviert würde. Auch hier ist den beiden Magnetfeldsensoren 1 und 2 vorzugsweise ein $\overline{RS}$-Flip-Flop als Zustandsspeicher nachzuschalten, durch welches eine Umkehr des gespeicherten Schaltzustandes in positive Logik erfolgt.

Die Figuren 4a und 4b zeigen ein alternatives Ausführungsbeispiel zu dem Rotationsschalter gemäß den Figuren 3a und 3b, bei welchem die Dauermagneten 3 und in radialer Richtung magnetisiert ist und die Magnetfeldsensoren 1 und 2 in radialer Richtung auf den Rotor R folgend angeordnet sind. Die Funktionalität der beiden Rotationsschalter gemäß Figur 3 und Figur 4 ist ansonsten identisch.

**Patentansprüche**

1.    Berührungsloser Rotationsschalter mit drei Schaltpositionen sowie

- einem im wesentlichen zylinderförmigen Rotor (R), in welchem ein Dauermagnet (3) angeordnet ist,
- einem ersten lagefest angeordneten Magnetfeldsensor (1) zur Erzeugung eines Verriegelungssignals, welcher bei verschwindendem Magnetfeld aktiviert ist, und
- einem zweiten lagefest angeordneten Magnetfeldsensor (2) zur Erzeugung eines Entriegelungssignals, welcher bei verschwindendem Magnetfeld aktiviert ist und eine betragsmäßig niedrigere Schaltschwelle als der erste Magnetfeldsensor (1) aufweist bzw. in einer Ruhestellung des Rotors (R) betragsmäßig stärker als der erste Magnetfeldsensor (1) von dem durch den Dauermagneten (3) hervorgerufenen Magnetfluß durchsetzt ist,

wobei in einer Ruhestellung des Rotors (R) beide Magnetfeldsensoren (1, 2) von dem durch den Dauermagneten (3) hervorgerufenen Magnetfluß durchsetzt und infolgedessen deaktiviert sind, während in einer Entriegelungsstellung nur der erste Magnetfeldsensor (1) und in einer Verriegelungsstellung nur der zweite Magnetfeldsensor (2) von dem durch den Dauermagneten (3) hervorgerufenen Magnetfluß durchsetzt ist.

**2.** Rotationsschalter nach Anspruch 1, **dadurch gekennzeichnet, daß** der im Rotor (R) angeordnete Dauermagnet (3) in axialer Richtung magnetisiert ist und daß die beiden Magnetfeldsensoren (1, 2) in axialer Richtung auf den Rotor (R) folgend angeordnet sind.

**3.** Rotationsschalter nach Anspruch 1, **dadurch gekennzeichnet, daß** der im Rotor (R) angeordnete Dauermagnet (3) in radialer Richtung magnetisiert ist und daß die beiden Magnetfeldsensoren (1, 2) in radialer Richtung auf den Rotor (R) folgend angeordnet sind.

**4.** Rotationsschalter nach einem der Ansprüche 1 bis 3, **dadurch gekennzeichnet, daß** die beiden Magnetfeldsensoren (1, 2) jeweils nur im deaktivierten Zustand ein von Null verschiedenes Signal erzeugen.

**5.** Rotationsschalter nach Anspruch 4, **dadurch gekennzeichnet, daß** beiden Magnetfeldsensoren (1, 2) jeweils ein Inverter nachgeschaltet ist.

**6.** Rotationsschalter nach einem der Ansprüche 1 bis 5, **dadurch gekennzeichnet, daß** der Dauermagnet (3) im wesentlichen kreissegmentförmig ist.

**7.** Berührungsloser Rotationsschalter mit drei Schaltpositionen sowie

- einem im wesentlichen zylinderförmigen Rotor (R), in welchem ein erster Dauermagnet (3) angeordnet ist,
- einem zweiten im Rotor (R) angeordneten Dauermagneten (4), welcher gegensinnig zum ersten Dauermagneten (3) magnetisiert ist,
- einem ersten lagefest angeordneten Magnetfeldsensor (1) zur Erzeugung eines Verriegelungssignals, welcher bei verschwindendem Magnetfeld deaktiviert ist, und
- einem zweiten Magnetfeldsensor (2) zur Erzeugung eines Entriegelungssignals, welcher bei verschwindendem Magnetfeld aktiviert ist,

wobei der erste Magnetfeldsensor (1) nur in einer Verriegelungsstellung des Rotors (R) von einem Magnetfluß, dem durch den ersten Dauermagneten (3) hervorgerufenen Magnetfluß, durchsetzt und infolgedessen aktiviert ist, und wobei der zweite Magnetfeldsensor (2) nur in einer Verriegelungsstellung des Rotors (R) und in einer Ruhestellung des Rotors (R) von einem Magnetfluß, dem durch den zweiten Dauermagneten (4) hervorgerufenen Magnetfluß, durchsetzt und infolgedessen deaktiviert ist.

**8.** Rotationsschalter nach Anspruch 7, **dadurch gekennzeichnet, daß** die beiden im Rotor (R) angeordneten Dauermagneten (3, 4) in axialer Richtung magnetisiert sind und daß die beiden Magnetfeldsensoren (1, 2) in axialer Richtung auf den Rotor (R) folgend angeordnet sind.

**9.** Rotationsschalter nach Anspruch 8, **dadurch gekennzeichnet, daß** sich der erste Dauermagnet (3) radial an den zweiten Dauermagneten (4) anschließt.

**10.** Rotationsschalter nach Anspruch 7, **dadurch gekennzeichnet, daß** die beiden im Rotor (R) angeordneten Dauermagneten (3, 4) in radialer Richtung magnetisiert sind und daß die beiden Magnetfeldsensoren (1, 2) in radialer Richtung auf den Rotor (R) folgend angeordnet sind.

**11.** Rotationsschalter nach Anspruch 10, **dadurch gekennzeichnet, daß** sich der erste Dauermagnet (3) axial an den zweiten Dauermagneten (4) anschließt.

**12.** Rotationsschalter nach einem der Ansprüche 7 bis 11, **dadurch gekennzeichnet, daß** der erste Magnetfeldsensor (1) nur im aktivierten Zustand ein von Null verschiedenes Signal erzeugt und daß der zweite Magnetfeldsensor (2) nur im deaktivierten Zustand ein von Null verschiedenes Signal erzeugt.

**13.** Rotationsschalter nach Anspruch 12, **dadurch gekennzeichnet, daß** dem ersten Magnetfeldsensor (1) ein Inverter nachgeschaltet ist.

**14.** Rotationsschalter nach Anspruch 12, **dadurch gekennzeichnet,daß** dem zweiten Magnetfeldsensor (2) ein Inverter nachgeschaltet ist.

**15.** Rotationsschalter nach einem der Ansprüche 7 bis 14, **dadurch gekennzeichnet, daß** beide Dauermagneten (3,4) im wesentlichen kreissegmentförmig sind.

**16.** Rotationsschalter nach einem der Ansprüche 7 bis 15, **dadurch gekennzeichnet, daß** sich der erste Dauermagnet (3) über einen kleineren Winkelbereich erstreckt als der zweite Dauermagnet (4).

**17.** Rotationsschalter nach einem der Ansprüche 1 bis 16, **dadurch gekennzeichnet, daß** die beiden Magnetfeldsensoren (1,2) durch Hall-Elemente realisiert sind.

## Claims

1. A noncontact rotary switch having three switching positions, and having

   a substantially cylindrical rotor (R) in which a permanent magnet (3) is arranged,

   a first magnetic field sensor (1) which is arranged in a fixed position for generating a blocking signal and is activated when the magnetic field disappears, and

   a second magnetic field sensor (2) which is arranged in a fixed position for generating an unblocking signal, is activated when the magnetic field disappears and has a lower switching threshold in quantitative terms than the first magnetic field sensor (1) or has passing through it in a rest position of the rotor (R), more strongly in quantitative terms than through the first magnet field sensor (1), the magnetic flux brought about by the permanent magnet (3),

   where in a rest position of the rotor (R) the magnetic flux brought about by the permanent magnet (3) passes through both magnetic field sensors (1, 2) and as a result they are both deactivated, while in an unblocking position the magnetic flux brought about by the permanent magnet (3) passes through only the first magnetic field sensor (1) and in a blocking position it passes through only the second magnetic field sensor (2).

2. A rotary switch according to Claim 1, **characterised in that** the permanent magnet (3) arranged in the rotor (R) is magnetised in the axial direction, and **in that** the two magnetic field sensors (1, 2) are arranged following the rotor (R) in the axial direction.

3. A rotary switch according to Claim 1, **characterised in that** the permanent magnet (3) arranged in the rotor (R) is magnetised in the radial direction, and **in that** the two magnetic field sensors (1, 2) are arranged following the rotor (R) in the radial direction.

4. A rotary switch according to anyone of Claims 1 to 3, **characterised in that** the two magnetic field sensors (1, 2) each generate a signal other than zero only in the deactivated condition.

5. A rotary switch according to Claim 4, **characterised in that** a respective inverter is connected downstream of each of the two magnetic field sensors (1, 2).

6. A rotary switch according to anyone of Claims 1 to 5, **characterised in that** the permanent magnet (3) is substantially in the shape of a circle segment.

7. A noncontact rotary switch having three switching positions, and having

   a substantially cylindrical rotor (R) in which a first permanent magnet (3) is arranged,

   a second permanent magnet (4) arranged in the rotor (R) and magnetised to have the opposite polarity to the first permanent magnet (3),

   a first magnetic field sensor (1) which is arranged in a fixed position for generating a blocking signal and is deactivated when the magnetic field disappears, and

   a second magnetic field sensor (2) for generating an unblocking signal and is activated when the magnetic field disappears,

   where a magnetic flux, namely the magnetic flux brought about by the first permanent magnet (3), passes through the first magnetic field sensor (1) only when the rotor (R) is in a blocking position and as a result it is activated, and

   where a magnetic flux, namely the magnetic flux brought about by the second permanent magnet (4), passes through the second magnetic field sensor (2) only when the rotor (R) is in a blocking position or a rest position and as a result it is deactivated.

8. A rotary switch according to Claim 7, **characterised in that** the two permanent magnets (3, 4) arranged in the rotor (R) are magnetised in the axial direction, and **in that** the two magnetic field sensors (1, 2) are arranged following the rotor (R) in the axial direction.

9. A rotary switch according to Claim 8, **characterised in that** the first permanent magnet (3) radially adjoins the second permanent magnet (4).

10. A rotary switch according to Claim 7, **characterised in that** the two permanent magnets (3, 4) arranged in the rotor (R) are magnetised in the radial direction, and **in that** the two magnetic field sensors (1, 2) are arranged following the rotor (R) in the radial direction.

11. A rotary switch according to Claim 10, **characterised in that** the first permanent magnet (3) axially adjoins the second permanent magnet (4).

12. A rotary switch according to anyone of Claims 7 to 11, **characterised in that** the first magnetic field sensor (1) only generates a signal other than zero in the activated condition, and **in that** the second magnetic field sensor (2) only generates a signal other than zero in the deactivated condition.

13. A rotary switch according to Claim 12, **characterised in that** an inverter is connected downstream of the first magnetic field sensor (1).

**14.** A rotary switch according to Claim 12, **characterised in that** an inverter is connected downstream of the second magnetic field sensor (2).

**15.** A rotary switch according to anyone of Claims 7 to 14, **characterised in that** both permanent magnets (3, 4) are substantially in the shape of a circle segment.

**16.** A rotary switch according to anyone of Claims 7 to 15, **characterised in that** the first permanent magnet (3) extends over a smaller angle than the second permanent magnet (4).

**17.** A rotary switch according to anyone of Claims 1 to 16, **characterised in that** the two magnetic field sensors (1, 2) are in the form of Hall effect elements.


**Revendications**

**1.** Commutateur rotatif sans contact comportant trois positions de commutation et

un rotor essentiellement cylindrique (R), dans lequel est agencé un aimant permanent (3);

un premier capteur de champ magnétique à agencement fixe (1) destiné à émettre un signal de verrouillage, activé en cas de suppression du champ magnétique, et

un deuxième capteur de champ magnétique à agencement fixe (2) destiné à émettre un signal de déverrouillage, activé en cas de suppression du champ magnétique, et ayant un seuil de commutation quantitativement inférieur à celui du premier capteur de champ magnétique (1), ou traversé dans une position de repos du rotor (R) par un flux magnétique produit par l'aimant permanent (3) quantitativement supérieur à celui du premier capteur de champ magnétique (1),

les deux capteurs de champ magnétique (1, 2) étant, dans une position de repos du rotor (R), traversés par le flux magnétique produit par l'aimant permanent (3) et étant ainsi désactivés, seul le premier capteur de champ magnétique (1) étant traversé par le flux magnétique produit par l'aimant permanent (3) dans la position de déverrouillage et seul le deuxième capteur de champ magnétique (2) étant traversé par le flux magnétique produit par l'aimant permanent (3) dans la position de verrouillage.

**2.** Commutateur rotatif selon la revendication 1, **caractérisé en ce que** l'aimant permanent (3) agencé dans le rotor (R) est aimanté dans la direction axiale, les deux capteurs de champ magnétique (1, 2) étant agencés de manière successive dans la direction axiale sur le rotor (R).

**3.** Commutateur rotatif selon la revendication 1, **caractérisé en ce que** l'aimant permanent (3) agencé dans le rotor (R) est aimanté dans la direction radiale, les deux capteurs de champ magnétique (1, 2) étant agencés de manière successive dans la direction radiale sur le rotor (R).

**4.** Commutateur rotatif selon l'une des revendications 1 à 3, **caractérisé en ce que** les deux capteurs de champ magnétique (1, 2) n'émettent respectivement un signal différent de zéro que dans l'état désactivé.

**5.** Commutateur rotatif selon la revendication 4, **caractérisé en ce qu'**un inverseur est respectivement monté derrière les deux capteurs de champ magnétique (1, 2).

**6.** Commutateur rotatif selon l'une des revendications 1 à 5, **caractérisé en ce que** l'aimant permanent (3) a pour l'essentiel la forme de segments circulaires.

**7.** Commutateur rotatif sans contact comportant trois positions de commutation; et

un rotor essentiellement cylindrique (R), dans lequel est agencé un premier aimant permanent (3);

un deuxième aimant permanent (4) agencé dans le rotor (R), ayant une aimantation opposée à celle du premier aimant permanent (3);

un premier capteur de champ magnétique à agencement fixe (1) destiné à émettre un signal de verrouillage, désactivé lors de la suppression du champ magnétique; et ,

un deuxième capteur de champ magnétique (2) destiné à émettre un signal de déverrouillage, activé lors de la suppression du champ magnétique;

le premier capteur de champ magnétique (1) étant uniquement traversé dans une position de verrouillage du rotor (R) par un flux magnétique, le flux magnétique produit par le premier aimant permanent (3), et étant par suite activé;

le deuxième capteur de champ magnétique (2) étant uniquement traversé dans une position de verrouillage du rotor (R) et dans une position de repos du rotor (R) par un flux magnétique, le flux magnétique produit par le deuxième aimant permanent (4), et étant par suite désactivé.

**8.** Commutateur rotatif selon la revendication 7, **caractérisé en ce que** les deux aimants permanents (3, 4) affectés au rotor (R) sont aimantés dans la direction axiale, les deux capteurs de champ magnétique (1, 2) étant agencés de manière successive dans la direction axiale sur le rotor (R).

**9.** Commutateur rotatif selon la revendication 8, **ca-**

**ractérisé en ce que** le premier aimant permanent (3) est agencé radialement derrière le deuxième aimant permanent (4).

10. Commutateur rotatif selon la revendication 7, **caractérisé en ce que** les deux aimants permanents (3, 4) agencés dans le rotor (R) sont aimantés dans la direction radiale, les deux capteurs de champ magnétique (1, 2) étant agencés de manière successive dans la direction radiale sur le rotor (R).

11. Commutateur rotatif selon la revendication 10, **caractérisé en ce que** le premier aimant permanent (3) est agencé axialement derrière le deuxième aimant permanent (4).

12. Commutateur rotatif selon l'une des revendications 7 à 11, **caractérisé en ce que** le premier capteur de champ magnétique (1) n'émet un signal différent de zéro que dans l'état activé, le deuxième capteur de champ magnétique (2) n'émettant un signal différent de zéro que dans l'état désactivé.

13. Commutateur rotatif selon la revendication 12, **caractérisé en ce qu'**un inverseur est monté derrière le premier capteur de champ magnétique (1).

14. Commutateur rotatif selon la revendication 12, **caractérisé en ce qu'**un inverseur est monté derrière le deuxième capteur de champ magnétique(2).

15. Commutateur rotatif selon l'une des revendications 7 à 14, **caractérisé en ce que** les deux aimants permanents (3, 4) ont pour l'essentiel la forme de segments circulaires.

16. Commutateur rotatif selon l'une des revendications 7 à 15, **caractérisé en ce que** le premier aimant permanent (3) s'étend sur un intervalle angulaire plus petit que le deuxième aimant permanent (4).

17. Commutateur rotatif selon l'une des revendications 1 à 16, **caractérisé en ce que** les deux capteurs de champ magnétique (1, 2) sont réalisés par des éléments à effet Hall.

**Fig. 1**

**Fig. 2**

Fig. 3a

Fig. 3b

Fig. 4a

Fig. 4b